Europäisches Patentamt

European Patent Office

Office européen des brevets

(11) Numéro de publication: **0 266 231**
A1

## (12) DEMANDE DE BREVET EUROPEEN

(21) Numéro de dépôt: **87402042.3**

(22) Date de dépôt: **14.09.87**

(51) Int. Cl.⁴: **G 01 R 19/25**
H 01 F 40/06

(30) Priorité: **16.09.86 FR 8612933**

(43) Date de publication de la demande:
**04.05.88 Bulletin 88/18**

(84) Etats contractants désignés:
**CH DE FR GB IT LI SE**

(71) Demandeur: **ALSTHOM**
**38, avenue Kléber**
**F-75784 Paris Cédex 16 (FR)**

(72) Inventeur: **Ebersohl, Gérard**
**282 Chemin de Fontanières**
**F-69350 La Mulatiere (FR)**

**Frayce, Yves**
**50 Chemin des Fonds**
**F-69110 Sainte Foy Les Lyon (FR)**

(74) Mandataire: Weinmiller, Jürgen et al
**Lennéstrasse 9 Postfach 24**
**D-8133 Feldafing (DE)**

(54) **Dispositif pour l'acquisition numérique d'un courant électrique alternatif issu d'un transformateur de courant à tore magnétique saturable.**

(57) Dispositif pour l'acquisition numérique d'un courant électrique alternatif issu d'un transformateur de courant à tore magnétique saturable, comportant à la suite du transformateur de courant (3), un échantillonneur (4) faisant partie d'un convertisseur analogique-numérique et, entre l'échantillonneur (4) et le transformateur de courant (3) un filtre (1) analogique, sélectif, passe-bande centré sur la fréquence fondamentale du courant électrique alternatif et raccordé au circuit secondaire du transformateur de courant (3) par un étage adaptateur d'impédance (2). Le filtre permet d'élargir le signal impulsionnel délivré par le transformateur de courant (3) lorsqu'il est saturé afin que les impulsions ne passent pas inaperçues au travers de l'échantillonnage tout en n'intervenant que très peu sur la forme du signal délivré par le transformateur de courant (3) lorsqu'il n'est pas saturé.

FIG.4

EP 0 266 231 A1

## Description

### Dispositif pour l'acquisition numérique d'un courant électrique alternatif issu d'un transformateur de courant à tore magnétique saturable

La présente invention concerne les circuits numériques d'analyse de courant alternatif à fréquence industrielle comportant en entrée un transformateur de courant à tore magnétique saturable.

Dans ces circuits, le traitement numérique d'un courant électrique alternatif à fréquence industrielle, 50 ou 60 Hz débute par un échantillonnage et une conversion analogique-numérique des échantillons à une fréquence maximale de l'ordre de 500 Hz imposée par la rapidité des convertisseurs analogiques-numériques usuels et par les durées des calculs effectués ultérieurement sur les échantillons numérisés pour en déduire les propriétés fondamentales de l'onde sinuoïdale de courant : amplitude, phase, dissymétrie.....à partir desquelles sont habituellement établis les critères de déclenchement des protections.

Le transformateur de courant, qui assure un isolement électrique et un simple changement d'échelle, est dimensionné pour avoir, en fonctionnement normal, un tore magnétique non saturé et reproduire fidèlement au secondaire la forme d'onde de courant d'allure sinuoïdale appliquée à son primaire. Il arrive cependant, dans des conditions exceptionnelles de fonctionnement qui sont celles pour lesquelles les protections doivent impérativement se déclencher, que le tore magnétique du transformateur de courant se sature provoquant l'apparition au secondaire d'une forme d'onde en impulsions alternativement positives et négatives qui est mal perçue au travers de l'échantillonnage et peut même être complètement ignorée dès que la largeur des impulsions devient de l'ordre de la période d'échantillonnage ou lui est inférieure.

Le présente invention a pour but d'éviter l'inconvénient précité en altérant le moins possible la forme du signal délivré par le transformateur de courant lorsqu'il n'est pas saturé, cela afin d'améliorer la sûreté de fonctionnement pour les dispositifs de protection utilisant un traitement numérique du signal sans amoindrir leur précision.

Elle a pour objet un dispositif pour l'acquisition numérique d'un courant électrique alternatif issu d'un transformateur de courant à tore magnétique comportant, à la suite du transformateur de courant, un échantillonneur et, entre l'échantillonneur et le transformateur de courant, un filtre analogique sélectif passe-bande centré sur la fréquence du courant alternatif.

Le filtre analogique sélectif passe-bande a, de préférence, une sélectivité de l'ordre de 1,6 et un temps de réponse de l'ordre d'une période du courant alternatif.

D'autres caractéristiques et avantages de l'invention ressortiront de la description ci-après d'un mode de réalisation donné à titre d'exemple. Cette descritpion sera faite en regard du dessin dans lequel :

- les figures 1, 2, 3 illustrent la forme de l'onde de courant délivrée par un transformateur de courant à tore magnétique respectivement non saturé, peu saturé et très saturé,
- la figure 4 représente le schéma électrique d'un dispositif conforme à l'invention et
- les figures 5 et 6 sont des diagrammes explicitant le fonctionnement du dispositif de la figure 4.

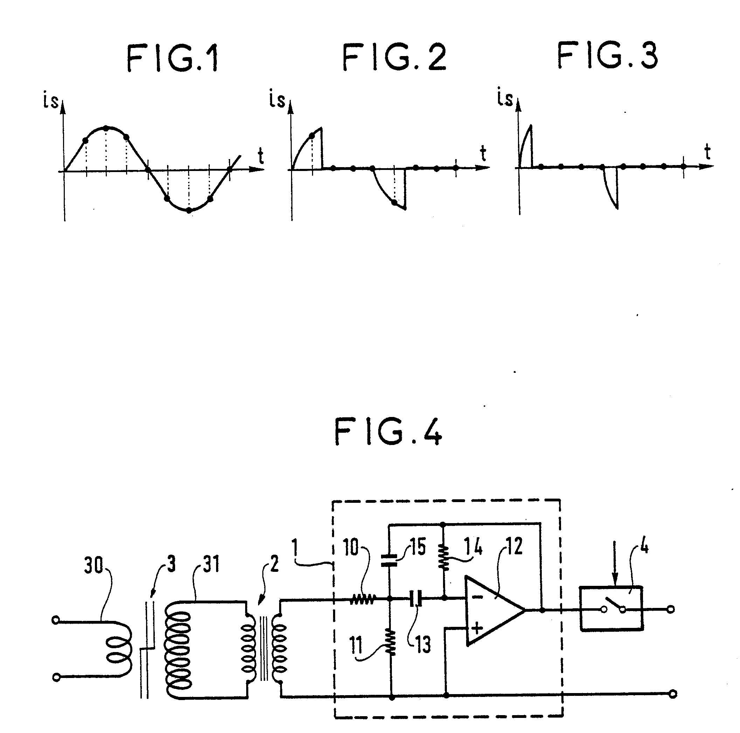

Tant que son tore magnétique n'est pas saturé un transformateur de courant délivre à son secondaire une onde de courant is de forme sinuoïdale telle que celle représentée à la figure 1, qui reproduit la forme de l'onde de courant appliquée au primaire et dont un échantillonnage de fréquence huit fois plus grande que la fréquence fondamentale, représenté par des points appuyés sur la figure, donne une image assez fidèle. Dès que le tore magnétique commence à se saturer la forme du courant is issu du secondaire du transformateur de courant ne suit plus celle du courant primaire car le courant secondaire is s'annule chaque fois que le tore magnétique atteint sa saturation et reste nul jusqu'au changement de polarité suivant. Dans le cas d'une faible saturation du tore magnétique, l'onde de courant issue du secondaire du transformateur de courant présente, comme représenté à la figure 2, des pics de saturation d'une largeur importante, de l'ordre du quart de la période fondamentale. Dans un échantillonnage de fréquence huit fois plus grande que la fréquence fondamentale il y a au plus trois échantillons non nuls par période ce qui rend la saturation difficilement détectable à moins d'un traitement numérique spécifique.

Dans la pratique, les pics dans le courant secondaire d'un transformateur de courant provoqués par la saturation du tore magnétique ont des aires égales, de surface constante, leur largeur diminuant et leur amplitude augmentant avec la saturation.

Lorsque la saturation du tore magnétique augmente, devenant moyenne ou forte, l'onde de courant issue du secondaire du transformateur de courant présente, comme représenté à la figure 3, des pics de saturation étroits ayant de fortes chances de ne pas apparaître dans un échantillonnage de fréquence huit fois plus grande que la fréquence fondamentale et par conséquent d'être complètement ignorés par le dispositif de traitement numérique recevant les échantillons.

Pour parvenir à la prise en compte effective des pics de saturation par un traitement numérique destiné à une onde sinuoïdale échantillonnée à une fréquence huit fois plus grande que la fréquence fondamentale tout en altérant le moins possible la forme de cette onde lorsqu'elle est issue d'un transformateur non saturé, on place dans le dispositif pour l'acquisition numérique, comme cela est représenté à la figure 4, un filtre analogique sélectif passe-bande 1 intercalé avec un circuit adaptateur d'impédance 2 entre le transformateur de courant 3 à tore magnétique saturable et l'échantillonneur 4 du convertisseur analogique-numérique non représenté délivrant les échantillons numériques.

Le circuit adaptateur d'impédance 2 est un transformateur non saturable, élévateur de tension qui ramène au primaire une faible impédance dans laquelle débite le secondaire du transformateur de courant 3.

Le filtre analogique passe-bande 1 est centré sur la fréquence fondamentale du courant alternatif industriel traversant le primaire 30 du transformateur de courant 3 qui est supposé être du 50 Hz. Il présente une sélectivité de 1,6 ce qui correspond à une bande passante de 33 Hz suffisamment large pour ne pas altérer la forme du signal délivré au secondaire 31 du transformateur de courant 3 lorsque ce dernier n'est pas saturé, et un temps de réponse de l'ordre de 20 ms correspondant à une période du courant alternatif industriel traversant le primaire 30 du transformateur de courant 3 et n'ajoutant qu'un faible délai au fonctoinnement d'une éventuelle protection. Il est réalisé sous la forme d'un filtre actif passe-bande d'ordre 2 défini par la fonction de transfert :

$$F(p) = \frac{p}{5{,}50 \ 10^{-3}p^2 + p + 500}$$

Il comporte en entrée un pont diviseur résistif 10, 11 connecté au secondaire du transformateur de l'étage adaptateur d'impédance 2. Un amplificateur opérationnel 12 placé à la suite a son l'entrée inverseuse connectée par l'intermédiaire d'un condensateur 13 au point milieu du pont résistif 10, 11 et son entrée non-inverseuse connectée à la masse. Il est pourvu d'une résistance 14 placée, en contre-réaction, directement entre sa sortie et son entrée inverseuse, et d'un condensateur 15 également placé en contre-réaction, entre sa sortie et le point milieur du pont diviseur résistif 10, 11.

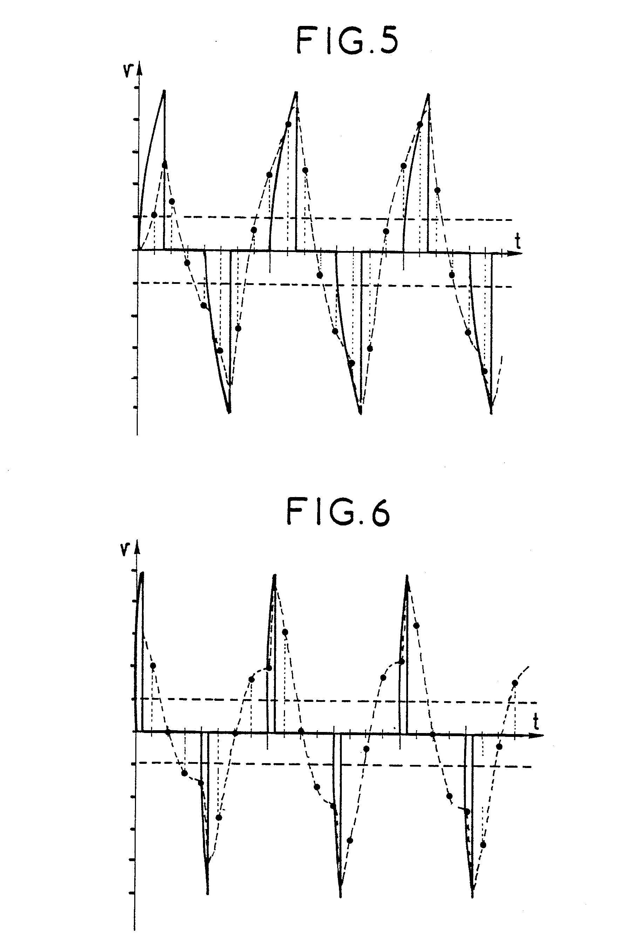

La figure 5 illustre le comportement du dispositif précédent dans le cas où le primaire du transformateur de courant 3 est traversé par un échelon de courant alternatif ayant une intensité égale à trois fois la valeur limite au-delà de laquelle se sature le tore magnétique du transformateur de courant 3. La courbe en trait plein représente, en fonction du temps, les impulsions de tension qui en résultent, en sortie du circuit d'adaptation d'impédance 2, à l'entrée du filtre analogique 1 tandis que la courbe en tirets représente, en fonction du temps, la réponse en tension du filtre 1 qui est appliquée à l'échantillonneur 4.

Pour les deux courbes, l'échelle des amplitudes adoptée en ordonnées a pour unité la valeur crête limite de la tension disponible en sortie de l'étage adaptateur d'impédance 2 lorsque le transformateur de courant 3 est à la limite de la saturation.

Les points appuyés placés sur la courbe en tirets donne un exemple d'échantillonnage de la réponse du filtre 1, exécuté à une fréquence huit fois plus grande que la fréquence fondamentale du courant alternatif traversant le primaire du transformateur de courant 3.

La figure 6 reprend les mêmes courbes que la figure 5 dans le cas où le primaire du transformateur de courant 3 est traversé par un courant alternatif industriel ayant une intensité égale à quarante fois la valeur limite au delà de laquelle se sature le tore magnétique du transformateur de courant 3.

On constate, dans les deux cas de moyenne et forte saturations du transformateur de courant 3 que le signal restitué par le filtre 1 se présente sous la forme d'un signal sinuoïdal très déformé dans lequel il n'y a plus de plage d'annulation de courant pouvant conduire des suites d'échantillons successifs nuls assimilables à une absence de courant et où il y a des plages supérieures à la valeur limite avant saturation de grande durée par rapport à la période d'échantillonnage qui permettent de percevoir les surintensités au travers le l'échantillonnage même en cas de saturation du transformateur de courant et ainsi d'assurer une protection sans faille.

On peut, sans sortir du cadre de la présente invention modifier certaines dispositions ou remplacer certains moyens par des moyens équivalents.

## Revendications

1/ Dispositif pour l'acquisition numérique d'un courant électrique alternatif issu d'un transformateur de courant (3) à tore magnétique saturable comportant un échantillonneur (4) disposé à la suite du transformateur de courant (3) caractérisé en ce qu'il comporte un filtre (1) analogique sélectif passe-bande centré sur la fréquence du courant alternatif et placé entre l'échantillonneur (4) et le transformateur de courant (3).

2/ Dispositif selon la revendication 1, caractérisé en ce que ledit filtre passe-bande (1) à un coefficient de sélectivité de l'ordre de 1,6.

3/ Dispositif selon la revendication 1, caractérisé en ce que ledit filtre passe-bande (1) a un temps de réponse de l'ordre d'une période du courant alternatif.

4/ Dispositif selon la revendication 1, caractérisé en ce que ledit filtre passe-bande (1) est du second d'ordre.

5/ Dispositif selon la revendication 4, caractérisé en ce que ledit filtre (1) passe-bande du second ordre est un filtre actif comportant en entrée un pont diviseur résistif (10, 11) suivi d'un amplificateur opérationnel (12) qui délivre le signal de sortie, dont l'entrée inverseuse est connectée par l'intermédiaire d'un condensateur (13) au point milieu du pont diviseur résistif (10, 11), et l'entrée non inverseuse connectée à la masse, et qui est pourvu d'une résistance (14) placée en contre-réaction, directement entre sa sortie et son entrée non inverseuse, et d'un condensateur (15) placé en contre-réaction, entre sa sortie et le point milieu du pont diviseur capacitif (10, 11).

# FIG.1     FIG.2     FIG.3

# FIG.4

0266231

# FIG.5

# FIG.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | IEEE TRANSACTIONS ON INSTRUMENTATION AND MEASUREMENT, vol. IM-19, no. 3, août 1970, pages 144-147, New York, US; F.J. EVANS et al.: "Use of a sampling scheme to detect transient saturation in protective current transformers" * Page 144, colonne 1, ligne 1 - page 145, colonne 1, ligne 2; figures 1,2; résumé * | 1 | G 01 R 19/25 H 01 F 40/06 |
| Y | FR-A-2 575 295 (ELECTRICITE DE FRANCE) * Page 3, ligne 22 - page 4, ligne 7; page 5, ligne 12 - page 5, ligne 26; figures 1a,2 * | 1 | |
| Y | EP-A-0 074 297 (MERLIN GREEN) * Page 3, ligne 35 - page 6, ligne 17; figures 1-7 * | 1 | |
| A | | 2 | |
| A | DE-A-1 616 545 (LICENTIA) * Page 2, ligne 19 - page 3, ligne 11; figures 2,3 * | 1,2 | DOMAINES TECHNIQUES RECHERCHES (Int. Cl.4) |
| A | ELECTRONICS & POWER, vol. 23, no. 1, janvier 1977, pages 52-55, Hitchin, GB; M. GROENENBOOM et al.: " Accurate measurement of d.c. and a.c. by transformer" * Page 53, colonne 1, lignes 7-10,26-29; figures 2-4 * | 2 | G 01 R 19/00 G 01 R 15/00 H 01 F 40/00 H 03 H 11/00 |
| A | TOUTE L'ELECTRONIQUE, no. 425, octobre 1977, pages 55-64, Paris, FR; M. QUERE: "Les filtres elliptiques" * Page 61; tableau 4 * | 4,5 | |

-/-

**Le présent rapport a été établi pour toutes les revendications**

| Lieu de la recherche | Date d'achèvement de la recherche | Examinateur |
|---|---|---|
| LA HAYE | 06-01-1988 | TRELEVEN C. |

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| P,A | US-A-4 652 810 (HAYASHI) <br> * Colonne 5, ligne 46 - colonne 6, ligne 18; figures 7,9 * <br> ----- | 5 | |

**DOMAINES TECHNIQUES RECHERCHES (Int. Cl.4)**

Le présent rapport a été établi pour toutes les revendications

| Lieu de la recherche | Date d'achèvement de la recherche | Examinateur |
|---|---|---|
| LA HAYE | 06-01-1988 | TRELEVEN C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.....................................................
& : membre de la même famille, document correspondant

EPO FORM 1503 03.82 (P0402)